# EUROPÄISCHE PATENTSCHRIFT

(11) **EP 4 208 908 B1**
(45) Veröffentlichungstag und Bekanntmachung des Hinweises auf die Patenterteilung: **18.11.2026**
(21) Anmeldenummer: 21765862.4
(22) Anmeldetag: 17.08.2021
(51) Int. Cl.: H01M 8/18

(54) **VERFAHREN ZUR ZUSTANDSÜBERWACHUNG EINES REDOX-FLOW-BATTERIE-SYSTEMS**
METHOD FOR MONITORING THE STATE OF A REDOX FLOW BATTERY SYSTEM
PROCÉDÉ DE SURVEILLANCE DE L'ÉTAT D'UN SYSTÈME DE BATTERIE REDOX

(30) Priorität: 04.09.2020 DE 102020123170
(43) Veröffentlichungstag der Anmeldung: 12.07.2023
(73) Patentinhaber: Liva Power Management Systems GmbH, 65926 Frankfurt am Main (DE)
(72) Erfinder: LÜTH, Thomas, 79104 Freiburg (DE)
(74) Vertreter: Fuchs Patentanwälte Partnerschaft mbB
(86) Internationale Anmeldenummer: PCT/EP2021/072826
(87) Internationale Veröffentlichungsnummer: WO 2022/048904

(56) Entgegenhaltungen:
- EP-A1- 3 790 148
- DE-A1- 102016 125 720
- JP-A- 2001 292 532

## Beschreibung

Die Erfindung betrifft ein Verfahren zum Betrieb eines Redox-Flow-Batterie-Systems insbesondere auf der Basis von Vanadium. Die Erfindung betrifft insbesondere Redox-Flow-Batterie-Systeme mit einer hohen Ausgangsspannung. Das Betriebsverfahren betrifft die Zustandsüberwachung des Batterie-Systems in Bezug auf den Gesundheitszustand (State of Health - SoH).

Um eine hohe Ausgangsspannung bei Redox-Flow-Batterie-Systemen zu erhalten, werden gewöhnlich mehrere Zellen elektrisch in Serie geschaltet. Diese Anordnung wird Stack genannt. Dies lässt sich jedoch nicht beliebig fortsetzen, da sonst der durch den Elektrolyt verursachte Nebenschlussstrom intolerabel hoch werden würde. Die Ausgangsspannung kann jedoch weiter erhöht werden, wenn mehrere Stacks in Serie geschaltet werden, wobei jeder Stack über eine separate Tankeinheit verfügt. Eine solche Einheit aus Stack und zugehöriger separater Tankeinheit wird Batteriemodul genannt. Die Reihenschaltung von mehreren Batteriemodulen wird herkömmlicherweise als String bezeichnet. Die Erfindung betrifft also ein Batterie-System, welches mehrere Batteriemodule umfasst, wobei das Batterie-System so ausgebildet ist, dass während dem Laden und Entladen des Systems die Batteriemodule in Serie geschaltet sind, d.h. einen String bilden.

Der SoH eines Redox-Flow-Batterie-Systems kann durch verschiedene Effekte negativ beeinflusst werden. Ein Ungleichgewicht des Elektrolyten, welcher in einer ungleichen Ionenkonzentration im negativen und positiven Elektrolyten besteht, kann den SoH negativ beeinflussen. Eine solches Ungleichgewicht wird in der Regel durch die sogenannte mittlere Oxidationsstufe (average oxidation state - AOS) beschrieben. Ein AOS, welcher von +3,5 abweicht, zeigt ein solches Ungleichgewicht an. Ein solches Ungleichgewicht kann schon von Betriebsbeginn an bestehen oder im Laufe des Betriebs größer werden. Das letztere kann durch Vanadium Oxidation, weitere chemische Nebenreaktionen sowie durch den "crossover" an den Membranen der Stacks verursacht werden. Ein solches Ungleichgewicht des Elektrolyten wird auch oft als Verschiebung des Elektrolyten bezeichnet. Eine weitere Möglichkeit für ein Ungleichgewicht des Elektrolyten besteht darin, dass das Volumen des negativen Elektrolyten von dem Volumen des positiven Elektrolyten abweichen kann. Dabei kann das gesamte Elektrolyt-Volumen eines Batteriemoduls und/oder das sich in den Zellen befindliche Elektrolyt-Volumen eine solche Abweichung aufweisen. Im letzten Fall kann z.B. eine Luftblase in einer oder mehreren Zellen die Ursache sein. Auch ein durch unterschiedliches Elektrolyt-Volumen verursachtes Ungleichgewicht kann mit der Zeit größer werden.

Aus dem Stand der Technik ist bekannt, dass eine Verschiebung des Elektrolyten mit Hilfe einer OCV-Zelle und einer Referenzzelle (bzw. drei Halbzellen) detektiert werden kann. Dabei steht OCV für die sogenannte "open circuit voltage" (siehe unten). Es ergeben sich hierbei jedoch Probleme, die durch die eventuell begrenzte Langzeitstabilität der Referenzzelle verursacht werden (vgl. die WO 2018/237181 A1). Außerdem kann ein durch unterschiedliches Elektrolyt-Volumen verursachtes Ungleichgewicht nicht mit Hilfe von Referenzzellen detektiert werden.

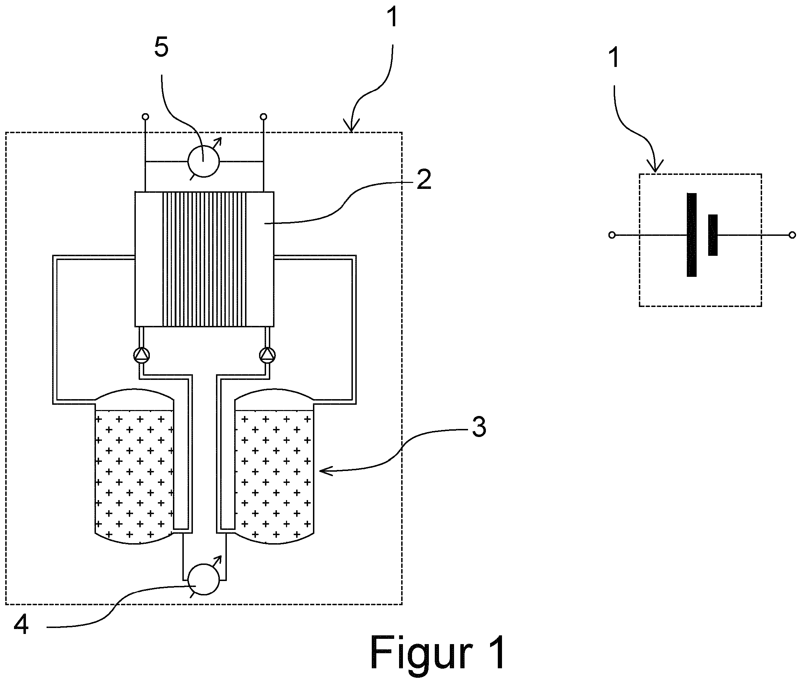

Außerdem wurde ein Verfahren beschrieben, bei dem ein Elektrolyt-Ungleichgewicht beim erstmaligen Laden einer Redox-Flow-Batterie bestimmt wurde ("Electrolyte Imbalance Determination of a Vanadium Redox Flow Battery by Potential-Step Analysis of the Initial Charging", Kirstin Beyer, Jan grosse Austing, Barbara Satola, Timo Di Nardo, Marco Zobel,Carsten Agert in European Chemical Societies Publishing ChemSusChem 2020, 13, 2066- 2071). Dabei können bei einem verschobenen Elektrolyten während dem erstmaligen Laden zwei voneinander separierte Potentialstufen detektiert werden, während ein idealer Elektrolyt dabei nur eine Potentialstufe aufweist. Dabei ist der zeitliche Abstand zwischen den zwei Potentialstufen ein Maß für den SoH (siehe v.a. Figure 1 bis Figure 3).

Der Erfinder hat sich die Aufgabe gestellt ein Verfahren zur Zustandsüberwachung eines Redox-Flow-Batterie-Systems anzugeben, das in der Lage ist den Gesundheitszustand des Batterie-Systems während dem normalen Betrieb zu überwachen und dabei in der Lage ist, alle beschriebenen Arten von Elektrolyt-Ungleichgewicht zu detektieren.

Die Aufgabe wird erfindungsgemäß durch eine Ausführung entsprechend dem unabhängigen Anspruch gelöst. Weitere vorteilhafte Ausführungsformen der vorliegenden Erfindung finden sich in den Unteransprüchen.

Die erfindungsgemäßen Lösungen werden im Folgenden anhand von Figuren erläutert. Die Figuren zeigen im Einzelnen:
- Fig.1: Batteriemodul
- Fig.2: Batterie-System in einer ersten Ausführungsform
- Fig.3: Batterie-System in einer weiteren Ausführungsform
- Fig.4: Batterie-System in einer weiteren Ausführungsform
- Fig.5: Zeitlicher Verlauf von Potentialdifferenzwerten
- Fig.6: Zeitlicher Verlauf von Potentialdifferenzwerten
- Fig.7: Zeitlicher Verlauf von Potentialdifferenzwerten

Figur 1 zeigt auf der linken Seite in schematischer Darstellung ein Batteriemodul. Das Batteriemodul ist mit 1 bezeichnet. Das Batteriemodul umfasst eine Zellanordnung, welche mit 2 bezeichnet ist, und eine Tankeinrichtung, welche mit 3 bezeichnet ist. Bei der Zellanordnung 2 handelt es sich um eine Anordnung von einer Vielzahl von Redox-Flow-Zellen, welche beliebig angeordnet sein können. Beispielsweise könnte es sich um einen einzelnen Zell-Stack, eine Serienschaltung von mehreren Stacks, eine Parallelschaltung von mehreren Stacks, oder um eine Kombination von Serien- und Parallelschaltung von mehreren Stacks handeln. Die Tankeinrichtung 3 dient zum Speichern des Elektrolyten und zur Versorgung der Zellanordnung 2 mit Elektrolyt. Dazu umfasst die Tankeinrichtung 3 wenigstens zwei Tanks für negativen und positiven Elektrolyt, ein Rohrsystem zur Verbindung der Tanks mit der Zellanordnung 2 und Pumpen zum Fördern des Elektrolyten. Figur 1 zeigt dabei zwei separate Pumpen. Genauso gut könnte der Elektrolyt mit einer Doppelkopfpumpe gefördert werden, d.h. mit zwei Pumpen, welche über einen gemeinsamen Motor angetrieben werden. Die Tankeinrichtung 3 ist dabei so ausgebildet, dass sie alle Zellen der Zellanordnung 2 mit Elektrolyt versorgen kann. Fördern die Pumpen also den Elektrolyten, so werden alle Zellen der Zellanordnung 2 von demselben durchströmt.

Das in Figur 1 dargestellte Batteriemodul 1 umfasst zwei Messeinrichtungen, welche mit 4 und 5 bezeichnet sind. Dabei handelt es sich bei der Messeinrichtung, welche mit 4 bezeichnet ist, um eine Messeinrichtung zur Bereitstellung der sogenannte Leerlaufspannung (open circuit voltage - OCV). Der OCV-Wert ist ein Maß für den Ladezustand des Batteriemoduls (SoC). Die Messeinrichtung, welche mit 5 bezeichnet ist, ist eine Messeinrichtung zur Bereitstellung der Klemmenspannung der Zellanordnung 2 und damit auch des Batteriemoduls 1. Beim Laden bzw. Entladen des Batteriemoduls 1 unterscheidet sich die Klemmenspannung von der Leerlaufspannung um die Spannung, die über dem Innenwiderstand der Zellanordnung 2 abfällt. Mit beiden Messeinrichtungen 4 bzw. 5 wird eine Potentialdifferenz gemessen, welche jeweils zwischen einem ersten Potential des negativen Elektrolyten und einem zweiten Potential des positiven Elektrolyten gebildet wird. Bei der OCV-Messeinrichtung 4 befinden sich die Elektroden, welche die genannten Potentiale abgreifen in einer Messzelle, wobei die zugehörigen Kammern, in denen sich negativer und positiver Elektrolyt befinden, von einer Membran bzw. einem Separator getrennt werden. Bei der Messeinrichtung 5 zur Bereitstellung der Klemmenspannung befinden sich die Elektroden zum Abgreifen der genannten Potentiale in entsprechenden Zellen der Zellanordnung 2. Dabei hängt die gebildete Potentialdifferenz natürlich von der Anzahl der Zellen ab, die zwischen den Elektroden zum Abgreifen der Potentiale in Serie geschaltet sind. Wenn kein Lade- bzw. Entladestrom fließt, dann ist die Klemmenspannung ein Vielfaches des Potentials, welches an der OCV-Messeinrichtung abgegriffen wird, wobei der zugehörige Faktor durch die Anzahl der Zellen gegeben ist, die in der Zellanordnung 2 in Serie geschaltet sind.

Auf der rechten Seite von Figur 1 ist eine symbolhafte Darstellungsweise des Batteriemoduls 1 gezeigt. Diese symbolhafte Darstellungsweise wird im Folgenden verwendet.

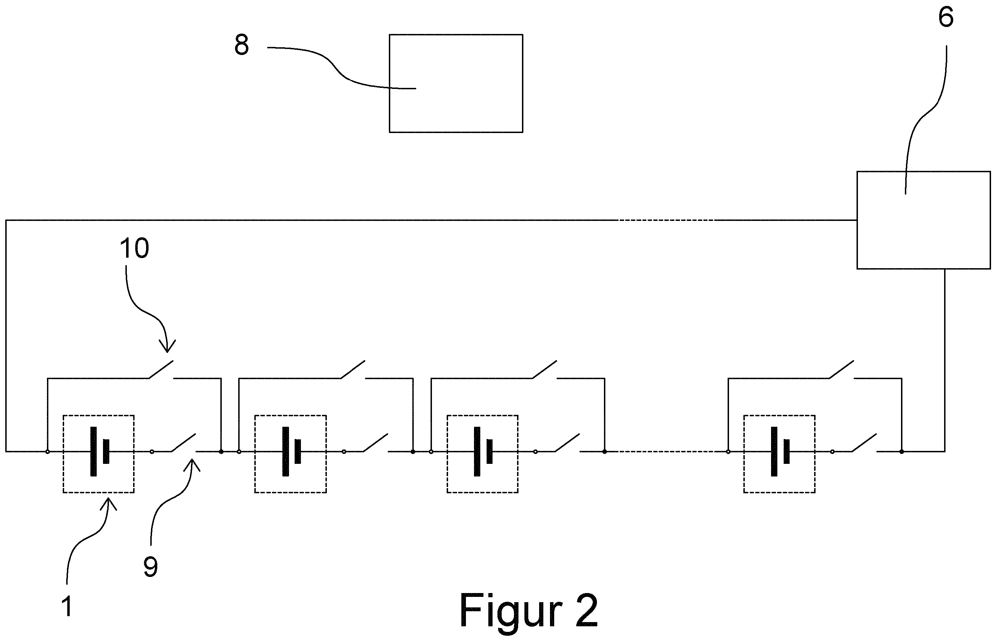

Figur 2 zeigt in schematischer Darstellung ein Batterie-System in einer ersten Ausführungsform. Das Batterie-System umfasst wenigstens zwei Batteriemodule, von denen eines mit 1 bezeichnet ist, einen bidirektionalen Umrichter (engl. bidirectional power conversion system - PCS), welcher mit 6 bezeichnet ist, und eine Steuereinrichtung, welche mit 8 bezeichnet ist. Die Batteriemodule 1 sind in Serie geschaltet und mit dem Umrichter 6 verbunden. In Figur 2 sind vier Batteriemodule dargestellt, wobei die gestrichelten Linien in der Serien-Schaltung eine beliebige Anzahl von weiteren Modulen andeuten sollen. Der Umrichter 6 übernimmt die Anbindung des Batterie-Systems an das Netz oder an ein übergeordnetes elektrisches System. Das Batterie-System umfasst ferner für jedes Batteriemodul 1 einen ersten Schalter, von denen einer mit 9 bezeichnet ist, und einen zweiten Schalter, von denen einer mit 10 bezeichnet ist. Die ersten Schalter 9 sind jeweils in Serie zu den Batteriemodulen 1 angeordnet, wobei es natürlich unerheblich ist, auf welcher Seite des jeweiligen Batteriemoduls der zugehörige Schalter 9 angeordnet ist. Die zweiten Schalter 10 sind jeweils in einer Umgehungsleitung (Bypass) um jeweils ein Batteriemodul 1 und den zugehörigen ersten Schalter 9 angeordnet. In Figur 2 sind alle Schalter 9 und 10 in geöffnetem Zustand dargestellt. Die Schalter werden durch die Steuereinrichtung 8 jedoch so angesteuert, dass von jedem Schalterpaar eines ersten und zweiten Schalters genau ein Schalter geschlossen und ein Schalter geöffnet ist (wechselweise geöffnet und geschlossen). D.h. ein Schalterpaar hat dabei genau zwei Schaltstellungen, wobei in der ersten Schaltstellung (erster Schalter 9 geschlossen und zweiter Schalter 10 geöffnet) das zugehörige Batteriemodul 1 sich in der Serienschaltung des Batterie-Systems befindet, und in der zweiten Schalterstellung (erster Schalter 9 geöffnet und zweiter Schalter 10 geschlossen) das zugehörige Batteriemodul 1 durch die Umgehungsleitung von der Serienschaltung des Batterie-Systems getrennt ist. Das Öffnen vom ersten Schalter 9 bei geschlossenen Schalter 10 verhindert dabei die Entladung des Moduls über die Umgehungsleitung. Die Steuereinrichtung 8 ist mit jedem Batteriemodul so verbunden, dass sie die Messwerte der Messeinrichtungen 4 bzw. 5 erfassen kann. Außerdem ist die Steuereinrichtung 8 mit jedem der Schalter 9 und 10 so verbunden, dass dieselbe die jeweilige Schalterstellung bestimmen kann, um die Batteriemodule 1 in die Serien-Schaltung hinein- oder aus der Serien-Schaltung herauszuschalten. Diese Verbindungen können auch drahtlos erfolgen.

Die in Figur 2 gezeigte Anordnung stellt die Minimalkonfiguration zur Ausführung des erfindungsgemäßen Betriebsverfahrens dar. Dabei sei erwähnt, dass bei den meisten Ausführungsformen des erfindungsgemäßen Betriebsverfahrens lediglich die Klemmenspannung der Batteriemodule 1 gemessen wird. D.h. bei diesen Ausführungsformen ist es nicht erforderlich, dass die Batteriemodule 1 auch eine Messvorrichtung zur Erfassung der OCV umfassen.

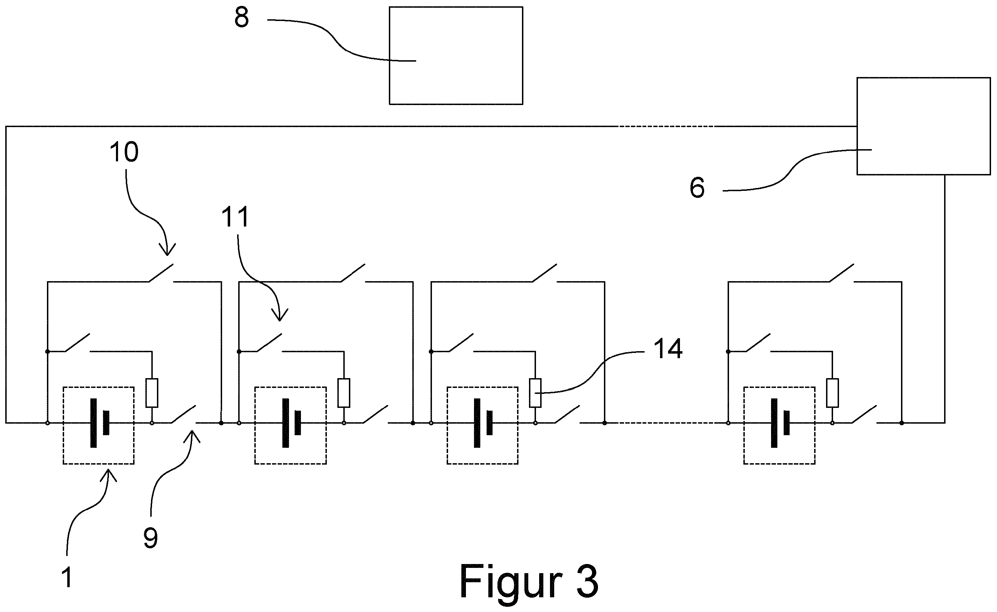

Figur 3 zeigt ein erfindungsgemäßes Batterie-System in einer weiteren Ausführungsform. Das Batterie-System umfasst für jedes Batteriemodul 1 zusätzlich einen weiteren, d.h. dritten Schalter, von welchen einer mit 11 bezeichnet ist. Ferner umfasst das Batterie-System für jedes Batteriemodul 1 einen Widerstand, von denen einer mit 14 bezeichnet ist. Der dritte Schalter 11 und der Widerstand 14 sind dabei jeweils in einer weiteren Bypass-Leitung um je ein Batteriemodul 1 so angeordnet, dass je ein Batteriemodul 1 über einen Widerstand 14 kurzgeschlossen wird, wenn der zugehörige dritte Schalter 11 geschlossen wird. Auch die dritten Schalter 11 werden von der Steuereinrichtung 8 betätigt. Mit Hilfe der Anordnung von Figur 3 kann jedes Batteriemodul durch Schließen des zugehörigen dritten Schalters 11 über einen zugehörigen Widerstand 14 selektiv entladen werden.

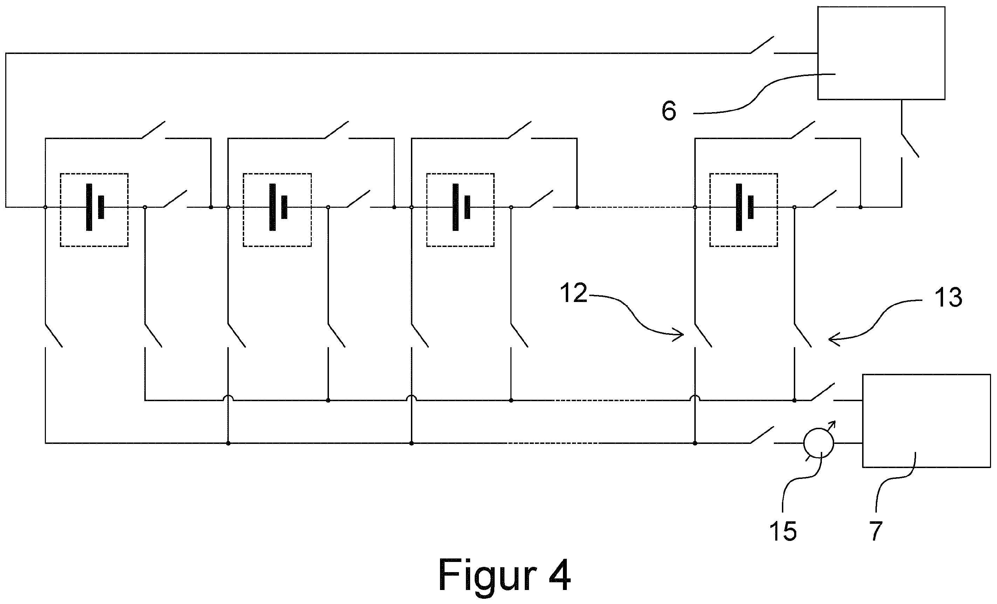

Figur 4 zeigt ein erfindungsgemäßes Batterie-System in einer weiteren Ausführungsform. Das Batterie-System umfasst einen weiteren Umrichter, welcher mit 7 bezeichnet ist. Außerdem umfasst das Batterie-System für jedes Batteriemodul zusätzlich einen vierten und fünften Schalter, welche mit 12 und 13 bezeichnet sind, und Leitungen, wobei die zusätzlichen Schalter und die Leitungen so miteinander und den Batteriemodulen verbunden sind, dass jedes Batteriemodul 1 separat mit dem weiteren Umrichter 7 verbunden werden kann. Auch die zusätzlichen Schalter 12 und 13 werden dabei von der Steuereinrichtung betätigt, welche in Figur 4 aus Platzgründen nicht dargestellt ist. Figur 4 zeigt auch noch weitere Schalter mit denen die Umrichter 6 und 7 jeweils von der restlichen Anordnung elektrisch getrennt werden können. Dies kann von Vorteil sein. Gegebenenfalls kann auch pro Umrichter nur ein Trennschalter verwendet werden. Solche Schalter können bei allen anderen Ausführungsformen ebenfalls zum Einsatz kommen. Es sei noch erwähnt, dass die Bezeichnungen "vierter" und "fünfter" Schalter allein der Klarheit geschuldet sind und nicht implizieren, dass in einer Ausführungsform mit diesen Schaltern auch notwendigerweise "dritte" Schalter vorhanden sein müssen. Die Ausführungsform gemäß Figur 4 ermöglicht ein Entladen der einzelnen Batteriemodule 1 über den weiteren Umrichter 7. Dazu genügt es, dass der weitere Umrichter 7 unidirektional ausgebildet ist. Er kann jedoch auch bidirektional ausgebildet sein, so dass er auch für das Laden der einzelnen Batteriemodule 1 verwendet werden kann, was beispielsweise zum SoC-Balancing des Strings oder für das Vorladen ("pre-charging") der Batteriemodule 1 von Nutzen sein kann.

Der Erfinder hat sich von dem Gedanken leiten lassen, dass der SoH eines Batterie-Systems von den SoHs der einzelnen Batteriemodule abhängt. Ferner hat der Erfinder erkannt, dass es möglich ist, den SoH eines Batteriemoduls auch während dem Entladen mit Hilfe der in der eingangs zitierten Schrift beschriebenen Potentialstufen zu überwachen. Das erfindungsgemäße Verfahren umfasst folgende Schritte:
S1: Ansteuern der ersten und zweiten Schalter 9, 10 so, dass wenigstens ein Batteriemodul 1 aus der Serienschaltung herausgeschaltet ist;
S2: Entladen von wenigstens einem Teilvolumen des Elektrolyten des im Schritt S1 aus der Serienschaltung herausgeschalteten wenigstens einen Batteriemoduls 1, wobei wiederholend eine Potentialdifferenz erfasst wird, und wobei die Potentialdifferenz zwischen einem ersten Potential des negativen Elektrolyten und einem zweiten Potential des positiven Elektrolyten des wenigstens einen herausgeschalteten Batteriemoduls 1 gebildet wird;
S3: Bestimmung des SoH des im Schritt S1 aus der Serienschaltung herausgeschalteten wenigstens einen Batteriemoduls aus den im Schritt S2 erfassten Potentialdifferenzwerten.

Dabei ist zu Schritt S2 anzumerken, dass das Vorzeichen der gebildeten Potentialdifferenz keinen Unterschied macht, d.h. die Potentialdifferenz kann genauso gut zwischen einem ersten Potential des positiven Elektrolyten und einem zweiten Potential des negativen Elektrolyten des wenigstens einen herausgeschalteten Batteriemoduls 1 gebildet werden. Oder anders ausgedrückt: Es kommt nur auf den Betrag der Potentialdifferenz an.

Je nach Ausbildung des Batterie-Systems kann dabei der Schritt S2 unterschiedlich ablaufen. Wenn das Batterie-System gemäß Figur 2 ausgebildet ist, dann erfolgt der Entladevorgang in Form einer Selbstentladung des in Schritt S1 herausgeschalteten wenigstens einen Batteriemoduls 1. Da eine solche Selbstentladung relativ langsam abläuft, ist es vorteilhaft, wenn sich das bzw. die betreffenden Batteriemodule 1 beim Herausschalten in Schritt 1 bereits nahe beim Ladezustand befinden, in dem die zu detektierenden Potentialstufen auftreten. Dies ist dann der Fall, wenn der OCV-Wert des betreffenden Batteriemoduls 1,4 Volt oder weniger beträgt. Ein entsprechendes Kriterium kann aus der Klemmenspannung abgeleitet werden.

Wenn das Batterie-System gemäß Figur 3 ausgebildet ist, dann erfolgt der Entladevorgang des in Schritt S1 herausgeschalteten wenigstens einen Batteriemoduls 1 dadurch, dass der zugehörige dritte Schalter 11 geschlossen wird, so dass sich das betreffende Batteriemodul über den zugehörigen Widerstand 14 entlädt. Dadurch kann der Entladevorgang entsprechend schneller ablaufen, so dass die Bestimmung des SoH weniger Zeit beansprucht.

In den in den beiden vorangehenden Abschnitten genannten Fällen wird die beim Entladen umgesetzte Energie letztlich in Wärme umgewandelt, d.h. geht verloren. Daher ist es auch deswegen von Vorteil, wenn sich das bzw. die betreffenden Batteriemodule 1 beim Herausschalten in Schritt 1 bereits nahe beim Ladezustand befinden, in dem die zu detektierenden Potentialstufen auftreten. Eine weitere Besonderheit der genannten Fälle besteht darin, dass im Prinzip mehr als ein Batteriemodul 1 im Schritt S1 aus der Serienschaltung des Batterie-Systems herausgeschaltet werden kann, so dass in den Schritten S2-S4 der SoH dieser Module simultan bestimmt werden kann. Die Anzahl der so simultan überwachten Module ist dadurch nach oben begrenzt, dass das Batterie-System in der Lage sein muss, den normalen Betrieb in der für die SoH-Bestimmung benötigten Zeit zu gewährleisten. Gängige Hochspannungs-Batteriesysteme können in jedem Betriebszustand das Herausschalten von einem Batteriemodul kompensieren. In manchen Betriebszuständen, z.B. wenn absehbar ist, dass in der Zeit die die SoH-Bestimmung benötigt, keine Leistungsaufnahme oder Leistungsabgabe des Batterie-Systems erfolgen muss, können auch problemlos mehr als ein Batteriemodul zur SoH-Bestimmung aus der Serienschaltung herausgeschaltet werden.

Wenn das Batterie-System gemäß Figur 4 ausgebildet ist, dann erfolgt der Entladevorgang des in Schritt S1 herausgeschalteten wenigstens einen Batteriemoduls 1 dadurch, dass die zugehörigen vieren und fünften Schalter 12 und 13 geschlossen werden, und das Entladen über den weiteren Umrichter 7 bewerkstelligt wird. In dieser Konfiguration kann immer nur genau ein Batteriemodul herausgeschaltet und mit dem weiteren Umrichter verbunden werden, um den zugehörigen SoH auf diese Weise zu bestimmen. Der Vorteil dieser Konfiguration liegt darin, dass die beim Entladen umgesetzte Energie nicht verloren geht, da dieselbe über den weiteren Umrichter 7 ins übergeordnete Netz eingespeist wird. Daher kann die SoH-Bestimmung weitgehend unabhängig vom jeweils vorliegen SoC des betreffenden Batteriemoduls gestartet werden. Wenn der SoC noch weit oberhalb des für die SoH-Bestimmung interessanten Bereiches liegt, dann kann die Entladung des betreffenden Batteriemoduls über den weiteren Umrichter 7 solange mit einem hohen Entladestrom erfolgen bis der OCV-Wert die oben erwähnte 1,4 Volt Marke erreicht hat. Danach kann die Entladung mit einem geringeren Strom erfolgen, so dass eine ausreichend hohe Auflösung der Potentialstufen gewährleistet ist. Dadurch kann die SoH-Bestimmung schneller und mit weniger Nebenreaktionen ablaufen.

Im Prinzip ist eine beliebige Kombination der Ausführungsformen gemäß der Figuren 2 bis 4 denkbar. So könnte beispielsweise ein Modul über den weiteren Umrichter 7 und ein anderes Modul simultan über den zugehörigen Widerstand 14 entladen werden, wobei der SoH der betreffenden Module ermittelt wird.

Weitere Varianten des erfindungsgemäßen Verfahrens ergeben sich, je nachdem welches Teilvolumen des Elektrolyten des betreffenden Batteriemoduls im Schritt S2 entladen wird. Diese Varianten hängen mit der jeweiligen Zielsetzung der SoH-Bestimmung eng zusammen.

Wenn eine Volumen-Abweichung des gesamten Elektrolyten, d.h. eine Abweichung zwischen dem Volumen von negativen Elektrolyt und dem Volumen von positiven Elektrolyten bestimmt werden soll, dann muss auch der gesamte Elektrolyt des betreffenden Batteriemoduls im Schritt S2 entladen werden. Dies wird dadurch erreicht, dass während der Ausführung von Schritt S2 der Elektrolytfluss durch die Zellanordnung 2 über die Pumpenleistung so eingestellt wird, dass sich ein überstöchiometrischer Fluss ergibt. In dieser Variante kann die Erfassung der Potentialdifferenz in Schritt S2 wahlweise mit der OCV-Zelle 4 oder mit der Messeinrichtung zur Erfassung der Klemmenspannung 5 erfolgen. Es ist klar, dass diese Variante zeitaufwändig ist, da entsprechend viel Energie beim Entladen umgesetzt werden muss. In Kombination mit den Varianten gemäß Figur 2 und 3 geht daher auch viel Energie verloren, so dass diese Kombinationen deutlich weniger vorteilhaft sind, als die Kombination mit der Variante gemäß Figur 4.

Wenn eine Verschiebung des Elektrolyten detektiert werden soll, dann genügt es, in Schritt S2 das in der Zellanordnung 2 enthaltene Teilvolumen von Elektrolyt zu entladen und damit für die SoH-Bestimmung zu verwenden. Dies wird dadurch erreicht, dass während der Ausführung von Schritt S2 der Elektrolytfluss durch die Zellanordnung 2 entweder komplett unterbunden (durch Abstellen der Pumpen) oder über die Pumpenleistung so eingestellt wird, dass sich ein unterstöchiometrischer Fluss ergibt. In dieser Variante muss die Erfassung der Potentialdifferenz in Schritt S2 mit der Messeinrichtung zur Erfassung der Klemmenspannung 5 erfolgen. Diese Variante ist auch dazu geeignet eine Luftblase in der Zellanordnung 2 zu detektieren. Eine Kombination mit den Varianten gemäß Figur 2-4 ist vorteilhaft möglich.

Es ist prinzipiell auch möglich nur das Teilvolumen, welches in der OCV-Zelle 4 enthalten ist, in Schritt S2 zu entladen und damit für die SoH-Bestimmung zu verwenden. In dieser Variante erfolgt die Erfassung der Potentialdifferenz in Schritt S2 mit der OCV-Zelle 4 selbst. Es ergibt sich jedoch der Nachteil, dass die SoH-Bestimmung auf diese Weise lange dauert, da die Entladung aufgrund von sehr kleinen Kurzschlussströmen sehr langsam ist.

Zur Bestimmung des SoH in Schritt S3 ist Folgendes zu sagen: Der SoH kann dabei absolut oder relativ bestimmt werden.

Die absolute Bestimmung des SoH erfolgt über die Bestimmung der Potentialstufen gemäß der eingangs erwähnten Schrift "Electrolyte Imbalance Determination of a Vanadium Redox Flow Battery by Potential-Step Analysis of the Initial Charging". Die Potentialstufen ergeben sich, wenn die in Schritt S2 erfassten Potentialdifferenzwerte als Funktion der Zeit betrachtet werden. Zur Bestimmung der genauen zeitlichen Lage der Stufe kann dabei die Kurve differenziert werden. Zur absoluten Bestimmung des SoH ist es außerdem notwendig, die Energie zu quantifizieren, die beim Entladen zwischen den beiden Potentialstufen umgesetzt wird. Dazu ist es notwendig, den Betrag des Entladestromes zu messen. Durch zeitliche Integration der Entladestromkurve ergibt sich die transferierte Ladung. Bei konstantem Entladestrom ist die Ladung proportional zur zwischen den Potentialstufen verstrichenen Zeit. Die umgesetzte Energie ist wiederum durch Integration der Potentialdifferenzen als Funktion der transferierten Ladung gegeben. Zur absoluten Bestimmung des SoH umfasst das Batterie-System daher eine Messeinrichtung zur Bestimmung der im Schritt S2 vorliegenden Entladestromstärke. Je nach Ausbildung des Batterie-Systems kann diese Messeinrichtung anders angeordnet sein. Figur 4 zeigt beispielhaft eine Messeinrichtung zur Bestimmung der Entladestromstärke, welche mit 15 bezeichnet ist. In anderen Ausführungsformen, wie z.B. der Ausführungsform gemäß Figur 3, kann das Batterie-System für jedes Batteriemodul eine separate Messeinrichtung zur Bestimmung der Entladestromstärke umfassen. In der Ausführungsform gemäß Figur 3 wären dieselben in Serie zu den Widerständen 14 angeordnet.

Zur relativen Bestimmung des SoH kann die aktuell aufgenommene Potentialdifferenzkurve mit einer zuvor aufgenommen Referenzkurve verglichen werden (s.u.). Eine weitere Möglichkeit besteht darin, bei den Potentialdifferenzkurven als SoH-Parameter nur die verstrichene Zeit zwischen den beiden Stufen zu betrachten. Diesen Fall könnte man auch als qualitative Bestimmung des SoH bezeichnen, da nur ein Parameter bestimmt wird, der in Relation zum eigentlichen (d.h. quantitativ bestimmten) SoH steht. Auch ein so bestimmter SoH-Parameter erlaubt eine relative SoH-Bestimmung.

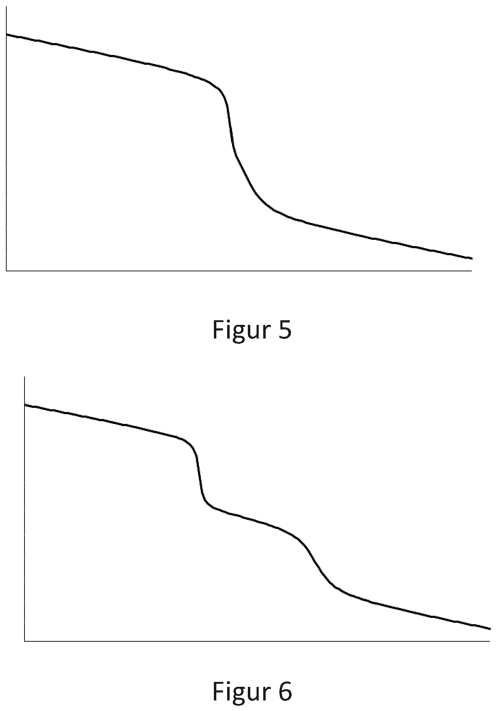

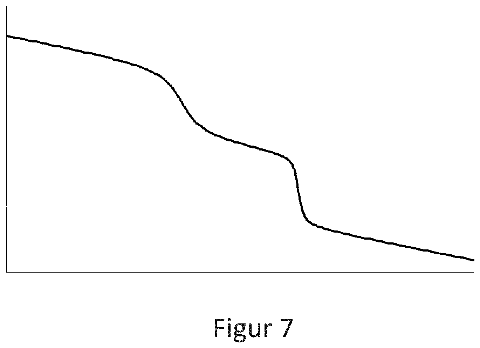

Die Figuren 5 bis 7 zeigen beispielhaft den zeitlichen Verlauf der im Schritt S2 erfassten Potentialdifferenzwerte, um die Bestimmung des SoH zu verdeutlichen. D.h. bei der x-Achse dieser Diagramme handelt es sich um die Zeit, und bei der der y-Achse um die erfassten Potentialdifferenzwerte. In der in Figur 5 dargestellten Kurve ist im Wesentlichen nur eine Potentialstufe zu beobachten. Der zugehörige Elektrolyt ist daher gut balanciert (AOS=3,5). In Figur 6 zeigt die Kurve zwei Potentialstufen, wobei die zeitlich erste steiler ausgeprägt ist als die zeitlich darauffolgende Potentialstufe. Der zugehörige Elektrolyt ist nicht gut balanciert und der AOS ist kleiner als 3,5. Auch die in Figur 7 dargestellte Kurve weist zwei Potentialstufen auf, wobei die zeitliche Abfolge im Vergleich zu Figur 6 umgekehrt ist. Der zugehörige Elektrolyt ist nicht gut balanciert und der AOS ist größer als 3,5. In Kenntnis der Entladestromstärke kann aus dem zeitlichen Abstand der beiden Potentialstufen der zugehörige AOS-Wert berechnet werden, so dass der SoH absolut bestimmt werden kann. Oft genügt es auch den SoH relativ zu bestimmen, z.B. um zu entscheiden, wann bei einem Batteriemodul der Elektrolyt regeneriert werden muss. Dazu können viele geeignete Metriken verwendet werden. Zum Beispiel könnten die erfassten Potentialdifferenzkurven mit einer entsprechenden Referenzkurve verglichen werden, welche bei der Inbetriebnahme oder nach einer vorangehenden Regeneration des Elektrolyten aufgenommen wurde. Ein geeignetes Maß für die Abweichung der beiden Kurven voneinander wäre dann beispielsweise die Summe der Quadrate der Differenzen. Hierzu kann der Fachmann ohne Probleme weitere geeignete Metriken finden.

Bei den oben beschriebenen erfindungsgemäßen Verfahren wird jeweils wenigstens ein Teilvolumen von Elektrolyt eines Batteriemoduls entladen. Dadurch ändert sich (d.h. verringert sich) natürlich auch der Ladezustand des betreffenden Batteriemoduls.

Falls man dies verhindern möchte, so kann man dem betreffenden Batteriemodul vor oder nach der Ausführung des beschriebenen Verfahrens eine entsprechende Energiemenge zuführen, so dass der Ladezustand des Batteriemoduls durch die Ausführung des Verfahrens letztlich nicht verändert wird. Die Energiezufuhr kann dabei in der Konfiguration nach Figur 4 vorteilhaft durch den weiteren Umrichter 7 erfolgen.

Abschließend ist zu erwähnen, dass im Schritt S2 die Entladung dann abgebrochen werden kann, wenn genügend viele Potentialdifferenzwerte aufgenommen worden sind, um im Schritt S3 den SoH bestimmen zu können. Zur Etablierung eines Abbruchkriteriums für die Entladung in Schritt S2 ist es daher von Vorteil, wenn die Schritte S2 und S3 wenigstens teilweise parallel ablaufen, d.h. wenn die Auswertung der aufgenommen Potentialdifferenzwerte schon beginnt, während noch weitere Potentialdifferenzwerte aufgenommen werden. Schritt S2 kann abgebrochen werden, wenn der Schritt S3 eines der folgenden Ergebnisse liefert:
- Detektion einer Potentialstufe, deren Stufenhöhe einen vordefinierten Schwellwert überschreitet;
- Detektion von zwei Potentialstufen;

Dabei sind als Schwellwerte für das erste Kriterium alle Werte geeignet, die im OCV-Äquivalenzbereich zwischen 0,7 und 1,2 Volt liegen. Besonders vorteilhaft sind Schwellwerte aus dem OCV-Äquivalenzbereich von 0,8 bis 1,1 Volt. Die Verwendung eines Abbruchskriteriums für den Schritt S2 hat den Vorteil, dass das erfindungsgemäße Verfahren schneller ausgeführt werden kann. Die Verwendung von modernen Rechensystemen ermöglicht die Bestimmung des SoH im Schritt S3 in vernachlässigbarer Zeit.

Dabei ist klar dass die im vorangehenden Abschnitt genannten Schwellwerte für Batterie-Systeme auf der Basis von Vanadium gelten. Für andere Batterie-Systeme gelten in der Regel andere Schwellwerte. Entsprechendes gilt für die oben erwähnten AOS-Werte.

### Bezugszeichenliste

- 1: Batteriemodul
- 2: Zellanordnung
- 3: Tankeinrichtung
- 4: Messeinrichtung zur Bestimmung der OCV (OCV-Zelle)
- 5: Messeinrichtung zur Bestimmung der Klemmenspannung
- 6: Bidirektionaler Umrichter (PCS)
- 7: Weiterer Umrichter
- 8: Steuereinrichtung
- 9: Erster Schalter
- 10: Zweiter Schalter
- 11: Dritter Schalter
- 12: Vierter Schalter
- 13: Fünfter Schalter
- 14: Widerstand
- 15: Messeinrichtung zur Bestimmung der Entladestromstärke

## Patentansprüche

1. Verfahren zur Zustandsüberwachung eines Redox-Flow-Batterie-Systems, wobei das Batterie-System wenigstens zwei Batteriemodule (1), einen bidirektionalen Umrichter (6) und eine Steuereinrichtung (8) umfasst, wobei die Batteriemodule (1) in Serie geschaltet und mit dem bidirektionalen Umrichter (6) verbunden sind, und wobei jedes Batteriemodul (1) eine Zellanordnung (2) mit einer Vielzahl von Redox-Flow-Zellen und eine Tankeinrichtung (3) zum Speichern von negativen und positiven Elektrolyt und zur Versorgung der Zellanordnung (2) mit Elektrolyt umfasst, und wobei das Batterie-System für jedes Batteriemodul (1) einen ersten Schalter (9) und einen zweiten Schalter (10) umfasst, wobei der erste Schalter (9) jeweils in Serie zu dem zugehörigen Batteriemodul (1) angeordnet ist, und der zweite Schalter (10) jeweils in einer Umgehungsleitung um das zugehörige Batteriemodul (1) und den zugehörigen ersten Schalter (9) angeordnet ist, und wobei die Steuereinrichtung (8) mit jedem der Schalter (9, 10) so verbunden ist, dass dieselbe die jeweilige Schalterstellung bestimmen kann, um die Batteriemodule (1) in die Serien-Schaltung hinein- oder aus der Serien-Schaltung herauszuschalten, **dadurch gekennzeichnet, dass** das Verfahren folgende Schritte umfasst:
S1: Ansteuern der ersten und zweiten Schalter (9, 10) so, dass wenigstens ein Batteriemodul (1) aus der Serienschaltung herausgeschaltet ist;
S2: Entladen von wenigstens einem Teilvolumen des Elektrolyten des im Schritt S1 aus der Serienschaltung herausgeschalteten wenigstens einen Batteriemoduls (1), wobei wiederholend eine Potentialdifferenz erfasst wird, und wobei die Potentialdifferenz zwischen einem ersten Potential des negativen Elektrolyten und einem zweiten Potential des positiven Elektrolyten des wenigstens einen herausgeschalteten Batteriemoduls (1) gebildet wird;
S3: Bestimmung des SoH des im Schritt S1 aus der Serienschaltung herausgeschalteten wenigstens einen Batteriemoduls (1) aus den im Schritt S2 erfassten Potentialdifferenzwerten;
und wobei die Schritte S2 und S3 wenigstens teilweise parallel ausgeführt werden, und wobei der Schritt S2 dann abgebrochen wird, wenn der Schritt S3 eines der folgenden Ergebnisse liefert:
- Detektion einer Potentialstufe, deren Stufenhöhe einen vordefinierten Schwellwert überschreitet;
- Detektion von zwei Potentialstufen;
wobei der vordefinierte Schwellwert in einem OCV-Äquivalenzbereich von 0,7 bis 1,2 Volt liegt.

2. Verfahren nach Anspruch 1, wobei das Batterie-System für jedes Batteriemodul (1) einen dritten Schalter (11) und einen Widerstand (14) umfasst, wobei der dritte Schalter (11) und der Widerstand (14) jeweils in einer Bypass-Leitung um je ein Batteriemodul (1) so angeordnet sind, dass je ein Batteriemodul (1) über einen Widerstand (14) kurzgeschlossen wird, wenn der zugehörige dritte Schalter (14) geschlossen wird, und wobei die Entladung im Schritt S2 über den Widerstand (14) erfolgt.

3. Verfahren nach Anspruch 1, wobei das Batterie-System einen weiteren Umrichter (7) und für jedes Batteriemodul (1) einen vierten und fünften Schalter (12, 13) und Leitungen umfasst, wobei die vierten und fünften Schalter (12, 13) und die Leitungen so miteinander und den Batteriemodulen (1) verbunden sind, dass jedes Batteriemodul (1) separat mit dem weiteren Umrichter (7) verbunden werden kann, und wobei die Entladung im Schritt S2 über den weiteren Umrichter (7) erfolgt.

4. Verfahren nach einem der vorherigen Ansprüche, wobei die Batteriemodule (1) jeweils eine Messeinrichtung zur Bestimmung der OCV (4) umfassen, und wobei die Erfassung der Potentialdifferenz im Schritt S2 mit Hilfe der Messeinrichtung zur Bestimmung der OCV (4) erfolgt.

5. Verfahren nach einem der Ansprüche 1 bis 3, wobei die Batteriemodule (1) jeweils eine Messeinrichtung zur Bestimmung der Klemmenspannung (5) umfassen, und wobei die Erfassung der Potentialdifferenz im Schritt S2 mit Hilfe der Messeinrichtung zur Bestimmung der Klemmenspannung (5) erfolgt.

6. Verfahren nach einem der Ansprüche 4 oder 5, wobei in Schritt S2 das gesamte Elektrolyt-Volumen des im Schritt S1 aus der Serienschaltung herausgeschalteten wenigstens einen Batteriemoduls (1) entladen wird.

7. Verfahren nach Anspruch 5, wobei in Schritt S2 das in der Zellanordnung (2) enthaltene Elektrolyt-Volumen des im Schritt S1 aus der Serienschaltung herausgeschalteten wenigstens einen Batteriemoduls (1) entladen wird.

8. Verfahren nach einem der vorangehenden Ansprüche, wobei das Batterie-System eine Messeinrichtung zur Erfassung der Stromstärke (15) des in Schritt S2 vorliegenden Entladestromes umfasst.

9. Verfahren nach Anspruch 1, wobei der vordefinierte Schwellwert in einem OCV-Äquivalenzbereich von 0,8 bis 1,1 Volt liegt.

10. Verfahren nach einem der vorangehenden Ansprüche, wobei im Schritt S3 der SoH relativ durch den Vergleich mit einer Referenzpotentialdifferenzkurve bestimmt wird.

11. Verfahren nach einem der vorangehenden Ansprüche, wobei im Schritt S3 der SoH durch die Ermittlung der zwischen zwei Stufen in einer erfassten Potentialdifferenzkurve verstrichenen Zeit bestimmt wird.

## Claims

1. A method for monitoring a state of a redox flow battery system, wherein the battery system comprises at least two battery modules (1), a bidirectional converter (6), and a control device (8), wherein the battery modules (1) are connected in a series circuit and are connected to the bidirectional converter (6), and wherein each battery module (1) comprises a cell arrangement (2) having a multiplicity of redox flow cells and a tank device (3) for storing negatively-charged and positively-charged electrolyte and for supplying electrolyte to the cell arrangement (2), and wherein the battery system comprises, for each battery module (1), a first switch (9) and a second switch (10), wherein the first switch (9) is arranged in series with the associated battery module (1), and the second switch (10) is arranged in a bypass line around the associated battery module (1) and the associated first switch (9), and wherein the control device (8) is connected to each of the switches (9, 10) such that the control device can determine the respective switch position in order to switch the battery modules (1) into the series circuit or out of the series circuit, **wherein** the method comprises the following steps:
S1: driving the first and second switches (9, 10) in such a way that at least one battery module (1) is switched out of the series circuit;
S2: discharging at least a sub-volume of the electrolyte of the at least one battery module (1) which has been switched out of the series circuit in step S1, wherein a potential difference is detected repeatedly, and wherein the potential difference is formed between a first potential of the negatively-charged electrolyte and a second potential of the positively-charged electrolyte of the at least one switched-out battery module (1);
S3: determining the SoH of the at least one battery module (1) which has been switched out of the series circuit in step S1 from the potential difference values detected in step S2;
and wherein steps S2 and S3 are implemented at least partially in parallel, and wherein step S2 is terminated when step S3 produces one of the following results:
- detection of a potential step having a step level that exceeds a predefined threshold value;
- detection of two potential steps;
wherein the predefined threshold value lies within an OCV, equivalence range of from 0.7 to 1.2 volts.

2. The method according to claim 1, wherein the battery system comprises, for each battery module (1), a third switch (11) and a resistor (14), wherein the third switch (11) and the resistor (14) are each arranged in a bypass line around in each case one battery module (1) in such a way that in each case one battery module (1) is short-circuited via a resistor (14) when the associated third switch (14) is closed, and wherein the discharging in step S2 takes place via the resistor (14).

3. The method according to claim 1, wherein the battery system comprises a further converter (7) and, for each battery module (1), a fourth and fifth switch (12, 13) and lines, wherein the fourth and fifth switches (12, 13) and the lines are connected to one another and to the battery modules (1) in such a way that each battery module (1) can be connected separately to the further converter (7), and wherein the discharging in step S2 takes place via the further converter (7).

4. The method according to any one of the preceding claims, wherein each of the battery modules (1) comprises a measuring device for determining the OCV (4), and wherein detecting the potential difference in step S2 is effected by way of the measuring device for determining the OCV (4).

5. The method according to any one of claims 1 to 3, wherein each of the battery modules (1) comprises a measuring device for determining the terminal voltage (5), and wherein detecting the potential difference in step S2 is effected by way of the measuring device for determining the terminal voltage (5).

6. The method according to any one of claims 4 or 5, wherein in step S2 the entire electrolyte volume of the at least one battery module (1) which has been switched out of the series circuit in step S1 is discharged.

7. The method according to claim 5, wherein in step S2 the electrolyte volume contained in the cell arrangement (2) of the at least one battery module (1) which has been switched out of the series circuit in step S1 is discharged.

8. The method according to any one of the preceding claims, wherein the battery system comprises a measuring device for determining the current intensity (15) of the discharge current in step S2.

9. The method according to claim 1, wherein the predefined threshold value lies within an OCV equivalence range of from 0.8 to 1.1 volts.

10. The method according to any one of the preceding claims, wherein in step S3 the SoH is determined relatively by comparison with a reference potential difference curve.

11. The method according to any one of the preceding claims, wherein in step S3 the SoH is determined by determining the time that has elapsed between two steps in a detected potential difference curve.

## Revendications

1. Procédé de surveillance de l'état d'un système de batterie Redox flow, dans lequel le système de batterie comprend au moins deux modules de batterie (1), un convertisseur bidirectionnel (6) et un dispositif de commande (8), dans lequel les modules de batterie (1) sont montés en série et reliés au convertisseur bidirectionnel (6), et dans lequel chaque module de batterie (1) comprend un agencement de cellules (2) avec une pluralité de cellules Redox flow et un dispositif de réservoirs (3) pour emmagasiner de l'électrolyte négatif et de l'électrolyte positif et pour alimenter l'agencement de cellules (2) en électrolytes, et dans lequel le système de batterie comprend, pour chaque module de batterie (1), un premier interrupteur (9) et un deuxième interrupteur (10), dans lequel le premier interrupteur (9) est disposé respectivement en série par rapport au module de batterie (1) associé, et le deuxième interrupteur (10) est disposé respectivement dans une ligne de dérivation autour du module de batterie (1) associé et du premier interrupteur (9) associé, et dans lequel le dispositif de commande (8) est relié à chacun des interrupteurs (9, 10) de manière à pouvoir déterminer la position d'interrupteur respective afin d'intégrer les modules de batterie (1) dans le montage en série ou de les déconnecter du montage en série, **caractérisé en ce que** le procédé comprend les étapes suivantes :
S1 : commander les premiers et deuxièmes interrupteurs (9, 10) de telle sorte qu'au moins un module de batterie (1) est déconnecté du montage en série ;
S2 : décharger au moins un volume partiel de l'électrolyte de l'au moins un module de batterie (1) déconnecté du montage en série à l'étape S1, une différence de potentiel étant détectée de manière répétée, et la différence de potentiel étant formée entre un premier potentiel de l'électrolyte négatif et un deuxième potentiel de l'électrolyte positif de l'au moins un module de batterie (1) déconnecté ;
S3 : déterminer l'état de santé SoH de l'au moins un module de batterie (1) déconnecté du montage en série à l'étape S1 à partir des valeurs de différence de potentiel détectées à l'étape S2 ;
et dans lequel les étapes S2 et S3 sont exécutées au moins partiellement en parallèle, et dans lequel l'étape S2 est interrompue lorsque l'étape S3 fournit l'un des résultats suivants :
- détection d'un palier de potentiel dont la hauteur de palier dépasse une valeur seuil prédéfinie;
- détection de deux paliers de potentiel ;
dans lequel la valeur seuil prédéfinie se situe dans une plage d'équivalence OCV de 0,7 à 1,2 Volt..

2. Procédé selon la revendication 1, dans lequel le système de batterie comprend, pour chaque module de batterie (1), un troisième interrupteur (11) et une résistance (14), dans lequel le troisième interrupteur (11) et la résistance (14) sont disposés respectivement dans une ligne de dérivation autour de chaque module de batterie (1) de telle sorte que chaque module de batterie (1) est court-circuité par l'intermédiaire d'une résistance (14) lorsque le troisième interrupteur (14) associé est fermé, et dans lequel la décharge à l'étape S2 s'effectue par l'intermédiaire de la résistance (14).

3. Procédé selon la revendication 1, dans lequel le système de batterie comprend un convertisseur supplémentaire (7) et, pour chaque module de batterie (1), un quatrième et un cinquième interrupteur (12, 13) ainsi que des lignes, dans lequel les quatrièmes et cinquièmes interrupteurs (12, 13) et les lignes sont reliés entre eux et aux modules de batterie (1) de telle sorte que chaque module de batterie (1) peut être relié séparément au convertisseur supplémentaire (7), et dans lequel la décharge à l'étape S2 s'effectue par l'intermédiaire du convertisseur supplémentaire (7).

4. Procédé selon l'une quelconque des revendications précédentes, dans lequel les modules de batterie (1) comprennent chacun un dispositif de mesure pour la détermination de l'OCV (4), et dans lequel la détection de la différence de potentiel à l'étape S2 s'effectue au moyen du dispositif de mesure pour la détermination de l'OCV (4).

5. Procédé selon l'une quelconque des revendications 1 à 3, dans lequel les modules de batterie (1) comprennent chacun un dispositif de mesure pour la détermination de la tension aux bornes (5), et dans lequel la détection de la différence de potentiel à l'étape S2 s'effectue au moyen du dispositif de mesure pour la détermination de la tension aux bornes (5).

6. Procédé selon l'une quelconque des revendications 4 ou 5, dans lequel, à l'étape S2, la totalité du volume d'électrolyte de l'au moins un module de batterie (1) déconnecté du montage en série à l'étape S1 est déchargée.

7. Procédé selon la revendication 5, dans lequel, à l'étape S2, le volume d'électrolyte contenu dans l'agencement de cellules (2) de l'au moins un module de batterie (1) déconnecté du montage en série à l'étape S1 est déchargé.

8. Procédé selon l'une quelconque des revendications précédentes, dans lequel le système de batterie comprend un dispositif de mesure pour la détection de l'intensité du courant (15) du courant de décharge présent à l'étape S2.

9. Procédé selon la revendication 1, dans lequel la valeur seuil prédéfinie se situe dans une plage d'équivalence OCV de 0,8 à 1,1 Volt.

10. Procédé selon l'une quelconque des revendications précédentes, dans lequel, à l'étape S3, l'état de santé SoH est déterminé de manière relative par comparaison avec une courbe de différence de potentiel de référence.

11. Procédé selon l'une quelconque des revendications précédentes, dans lequel, à l'étape S3, l'état de santé SoH est déterminé par la détermination du temps écoulé entre deux paliers dans une courbe de différence de potentiel détectée.
